# EUROPÄISCHE PATENTSCHRIFT

(11) **EP 2 145 717 B1**
(45) Veröffentlichungstag und Bekanntmachung des Hinweises auf die Patenterteilung: **23.03.2011**
(21) Anmeldenummer: 09008404.7
(22) Anmeldetag: 26.06.2009
(51) Int. Cl.: B23K 15/00, B23K 15/06, H01J 37/16, H01J 37/18

(54) **Kammeranordnung für eine Elektronenstrahlbearbeitungsvorrichtung mit einem Schlitten und einer drehbaren Scheibe**
Chamber assembly for an electron beam processing device with a slide and a rotating disc
Agencement de chambre pour un dispositif de traitement par rayons d'électrons avec un charriot et un disque rotatif

(30) Priorität: 17.07.2008 DE 102008033615
(43) Veröffentlichungstag der Anmeldung: 20.01.2010
(73) Patentinhaber: Global Beam Technologies AG., 82216 Maisach (DE)
(72) Erfinder: Vokurka, Franz, 39019 Dorf Tirol (Meran) (IT)
(74) Vertreter: Kramer - Barske - Schmidtchen

(56) Entgegenhaltungen:
- FR-A- 2 372 509
- JP-U- 50 117 125
- US-A- 3 424 891
- US-A- 3 586 812
- US-A1- 2004 084 420

## Beschreibung

Die Erfindung betrifft eine Kammeranordnung für eine Elelctronenstrahlbearbeitungsvorrichtung, insbesondere zum Elektronenstrahlschweißen von Werkstücken unter Vakuum, mit einem Schlittensystem.

Eine Elektronenstrahlbearbeitung wie das Elektronenstrahlschweißen von Werkstücken findet gewöhnlich in Kammern statt, in denen Haltewerkzeuge für die Werkstücke angeordnet sind. Die Haltewerkzeuge werden durch eine verschließbare Öffnung der Kammer mit Werkstücken beschickt und entladen. Die Bearbeitung findet dabei unter Vakuum statt, da der Elektronenstrahl unter atmosphärischen Bedingungen bei Normaldruck bereits auf kurzen Distanzen an Energiedichte verliert.

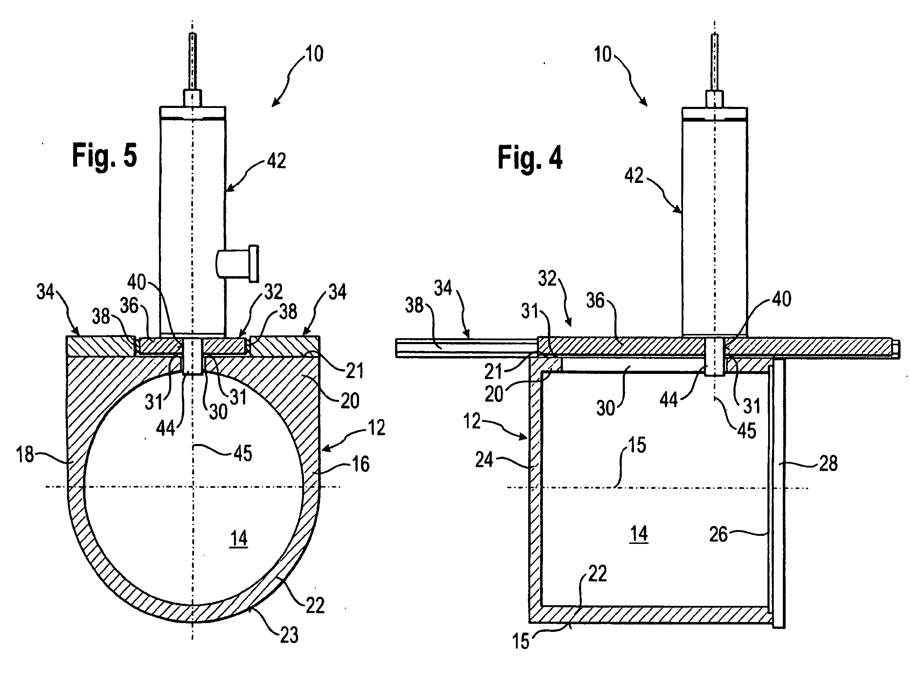

Die zum Schweißen erforderlichen relativen Bewegungen zwischen dem Elektronenstrahl und den Werkstücken werden außer durch Strahlablenkung auch z.B. durch ein Bewegen des Elektronenstrahlgenerators relativ zu dem Werkstück erzeugt. Der Elektronenstrahlgenerator ist dazu beispielsweise auf einem Längs- oder Kreuzschlittensystem montiert, das von einem Motobewegt wird. US 3 586 812 A und FR 2 372 509 A offenbaren jeweils eine Kammer zum Bearbeiten einer darin befindlichen Werkstücks unter Luftabschluss. US 3 424 891 A offenbart eine mobile Elektromenschweißhammer.
Eine Kammeranordnung 10 mit einem herkömmlichen Schlittensystem ist in Fig. 4 und Fig. 5 geneigt.

Die Kammeranordnung 10 weist ein Kammergehäuse 12 auf. Das Kammergehäuse 12 definiert einen Kammerinnenraum 14 mit einem kreisrunden Querschnitt senkrecht zu einer Längsachse 15 des Kammergehäuses 12 (siehe Fig. 5), in dem eine Elektronenstrahlbearbeitung wie z.B. ein Elektronenstrahlschweißen von Werkstücken unter Vakuum erfolgen kann. Das Kammergehäuse 12 weist zwei sich gegenüberliegende Seitenwände 16, 18 (Fig. 5), eine obere Wand 20 mit einer ebenen, sich in der Ansicht der Fig. 4 in horizontaler Richtung erstreckenden Oberseite 21, eine untere Wand 22 mit einer gewölbten Unterseite 23, eine ebene Rückwand 24, und eine der Rückwand 24 gegenüberliegende Be-/Entladeöffnung 26 auf. Die Seitenwände 16, 18 sind mit der Rückwand 24, der oberen Wand 20 und der unteren Wand 22 so fluiddicht verbunden, dass sich die obere Wand 20 und die untere Wand 22 gegenüberliegen und die Rückwand 24 senkrecht zu der oberen Wand 20 und der unteren Wand 22 angeordnet ist. Die Be-/Entladeöffnung 26 ist mittels einer Tür 28 dicht verschließbar. Die Be-/Entladeöffnung 26 weist um ihren Rand eine nicht gezeigte Dichtung auf, die sich im verschlossenen Zustand zwischen dem Rand der Be-/Entladeöffnung 26 und der Tür 28 befindet.

Die Oberseite 21 des Kammergehäuses 12 weist in ihrem mittleren Bereich eine schlitzförmige Öffnung 30 auf. Schlitzförmig bedeutet in diesem Zusammenhang, dass die schlitzförmige Öffnung 30 länger als breit ist, so dass sie in einer Draufsicht einem Langloch ähnlich ausgebildet ist. Die schlitzförmige Öffnung 30 erstreckt sich parallel zu der Längsachse 15 des Kammergehäuses 12 und somit in einer Richtung, die senkrecht zu der Rückwand 24 und der Be-/Entladeöffnung 26 verläuft. Wie der Darstellung der Fig. 4 zu entnehmen ist, beträgt der Abstand der schlitzförmigen Öffnung 30 bis zu der Be-/Entladeöffnung 26 ungefähr 25 % der Länge der schlitzförmigen Öffnung 30 und bis zu der Rückwand 24 weniger als 25 % der Länge der schlitzförmigen Öffnung 30. Demzufolge ist der jeweilige Abstand der schlitzförmigen Öffnung 30 bis zu der Be-/Entladeöffnung 26 und bis zu der Rückwand 24 kürzer als die Länge der schlitzförmigen Öffnung 30. Eine Dichtung 31 ist auf der Oberseite 21 so angeordnet, dass sie die schlitzförmige Öffnung 30 entlang deren Rand umgibt.

Die Kammeranordnung 10 weist weiter ein Schlittensystem 32 auf. Das Schlittensystem 32 weist zwei Fassungen 34, einen Schlitten 36 und zwei Linearführungen 38 auf. Die Fassungen 34 sind quaderförmig und weisen eine Länge auf, die der dreifachen Länge der schlitzförmigen Öffnung 30 entspricht. Folglich ragen die Fassungen 34 im montierten Zustand sowohl in dem Bereich der Rückwand 24 als auch in dem Bereich der Be-/Entladeöffnung 26 deutlich in Richtung der Längsachse 15 über die obere Wand 20 bzw. die Oberseite 21 hinaus. Die Fassungen 34 sind so auf der Oberseite 21 des Kammergehäuses 12 angeordnet, dass sie sich parallel zueinander beabstandet gegenüberliegen und zu der schlitzförmigen Öffnung 30 parallel sind. Der Abstand von jeder der sich zugewandten Seitenflächen der Fassungen 34 bis zu der schlitzförmigen Öffnung 30 beträgt jeweils ca. die doppelte Breite der schlitzförmigen Öffnung 30. Die Linearführungen 38 sind als Schienen ausgebildet und weisen die gleiche Länge wie die Fassungen 34 auf. Die Linearführungen 38 sind an den sich zugewandten Seitenflächen der Fassungen 34 angeordnet.

Der Schlitten 36 ist zwischen den Linearführungen 38 angeordnet. Der Schlitten 36 weist eine im Wesentlichen dem Abstand der Linearführungen 38 entsprechende Breite und eine Länge, die größer als die doppelte Länge der schlitzförmigen Öffnung 30 ist, auf. Der Schlitten 36 weist in seiner Mitte eine runde Öffnung 40 mit einem Durchmesser; der kleiner als die Breite der schlitzförmigen Öffnung 30 ist, auf. Der Schlitten 36 ist so zwischen den Fassungen 34 angeordnet, dass er zwischen diesen, geführt durch die Linearführungen 38, linear bewegbar ist und mit seiner dem Kammerinnenraum 14 zugewandten Seite auf der Dichtung 31 aufliegt. Die Öffnung 40 und die schlitzförmige Öffnung 30 überdecken sich auf Grund dieser Anordnung.

Ein Elektronenstrahlgenerator 42 weist ein Strahlrohr 44 auf, das an einer Unterseite des Elektronenstrahlgenerators 42 angeordnet und fest mit diesem verbunden ist. Der Elektronenstrahlgenerator 42 ist auf der dem Kammerinnenraum 14 abgewandten Seite des Schlittens 36 so angeordnet, dass das Strahlrohr 44 durch die Öffnung 40 und in die schlitzförmige Öffnung 30 ragt und der Elektronenstrahlgenerator 42 die Öffnung 40 fluiddicht umgibt. Der Elektronenstrahlgenerator 42 ist angepasst zum Erzeugen eines Elektronenstrahls, der sich durch das Strahlrohr 44 entlang einer Elektronenstrahlachse 45 in den Kammerinnenraum 14 fortpflanzt.

Während einer Elektronenstrahlbearbeitung kann der Schlitten 36 zusammen mit dem Elektronenstrahlgenerator 42 durch einen nicht gezeigten Antrieb so bewegt werden, dass der Elektronenstrahl an unterschiedliche Positionen in dem Kammerinnenraum 14 gelangen kann. Die geometrische Ausbildung des Schlittens 36 und der Fassungen 34 dient dazu, dass der Schlitten 36 in jeder Position auf der Dichtung 31 aufliegt und somit eine Abdichtung des Kammerinnenraums 14 gegenüber der äußeren Umgebung der Kammeranordnung 10 sichergestellt ist.

Es ist daher eine Aufgabe der Erfindung, eine Kammeranordnung anzugeben, die eine kompakte Anordnung zum Bewegen des Elektronenstrahlgenerators aufweist.

Diese Aufgabe wird durch eine Kammeranordnung gemäß Patentanspruch 1 gelöst.

Weitere vorteilhafte Ausführungsformen sind in den abhängigen Ansprüchen angegeben.

Die Kammeranordnung für eine Elektronenstrahlbearbeitungsvorrichtung weist ein Kammergehäuse, das einen Kammerinnenraum definiert und eine erste Öffnung aufweist, einen Schlitten, der im Bereich der ersten Öffnung bewegbar ist, einen Elektronenstrahlgenerator zum Erzeugen eines Elektronenstrahls entlang einer Elektronenstrahlachse, wobei der Elektronenstrahlgenerator an dem Schlitten so angeordnet ist, dass bei einer Bewegung des Schlittens im Bereich der ersten Öffnung der Elektronenstrahl durch die erste Öffnung hindurchgeht, und eine Scheibe auf. Die Scheibe ist zwischen dem Kammergehäuse und dem Schlitten angeordnet und ist um eine Drehachse, die senkrecht zu der ersten Öffnung ist, wenigstens zwischen einer ersten Position und einer zweiten Position drehbar und weist eine zweite Öffnung zumindest in einem Bereich der Scheibe, der sich in radialer Richtung von der Drehachse der Scheibe weg erstreckt, auf. Die Drehachse der Scheibe ist so angeordnet, dass sich die erste Öffnung und die zweite Öffnung bei einer Drehung der Scheibe zwischen der ersten Position und der zweiten Position wenigstens im Bereich der Elektronenstrahlachse überdecken. Dadurch ist es möglich, dass der Schlitten innerhalb der Maße des Kammergehäuses bewegt wird, das heißt, Abmessungen von Führungen für den Schlitten gehen nicht über die Größe bzw. die Maße des Kammergehäuses hinaus.

Vorteilhafterweise ist die erste Öffnung kreisrund, so dass dem Elektronenstrahlgenerator kombiniert mit einem XY-Schlitten erlaubt ist, dass der Elektronenstrahl ohne Ablenkung an jeden Punkt innerhalb der Ebene der ersten Öffnung bewegt werden kann.

Vorteilhafterweise ist die erste Öffnung schlitzförmig, so dass eine besonders kompakte Anordnung zum Bewegen des Elektronenstrahlgenerators möglich ist.

Vorteilhafterweise ist die zweite Öffnung schlitzförmig, so dass die Scheibe von einem Strahlrohr des Elektronenstrahlgenerators gedreht werden kann.

Vorteilhafterweise ist ein Flansch an dem Elektronenstrahlgenerator vorgesehen und sind eine Dichtung zwischen dem Flansch und der Scheibe die zweite Öffnung umgebend und eine Dichtung zwischen der Scheibe und dem Kammergehäuse die erste Öffnung umgebend vorgesehen, so dass der Kammerinnenraum gegenüber der äußeren Umgebung der Kammeranordnung abgedichtet bzw. abgeschlossen ist und die Abdichtung unabhängig von dem Schlitten bewirkt werden kann.

Vorteilhafterweise ist der Flansch integral mit dem Schlitten ausgebildet.

Vorteilhafterweise sind der Flansch und der Schlitten zwei separate Teile.

Vorteilhafterweise weist die Kammeranordnung einen XY-Schlitten als Schlitten auf.

Vorteilhafterweise weist der Elektronenstrahlgenerator ein Strahlrohr auf, wodurch die Scheibe durch das Strahlrohr gedreht werden kann.

Vorteilhafterweise wird die Scheibe durch das Strahlrohr gedreht, so dass eine gute Positionsgenauigkeit für einen Elektronenstrahl angegeben wird.

Vorteilhafterweise ist die Scheibe durch einen Antrieb zur Drehung antreibbar, so dass der Schlitten mittels des Strahlrohrs bewegt werden kann.

Vorteilhafterweise weist die zweite Öffnung eine Länge auf, die nicht größer als die halbe Länge der ersten Öffnung plus dem Durchmesser des Strahlrohrs des Elektronenstrahlgenerators ist, so dass ein größerer Abstand für die Drehachse von der ersten, Öffnung möglich ist, wodurch das Drehmoment zum Drehen der Scheibe vergrößert werden kann.

Vorteilhafterweise verläuft die Drehachse der Scheibe nicht durch die zweite Öffnung, so dass eine kleinere Fläche der zweiten Öffnung abgedichtet werden muss.

Vorteilhafterweise weist die Kammeranordnung eine Fassung mit parallel zueinander beanstandeten Ansätzen auf und ist der Schlitten an zwei sich zugewandten Seitenflächen der Ansätze gerührt, so dass eine besonders gute Führung möglich ist.

Vorteilhafterweise ist die Scheibe durch ein Lager, das sich zwischen der Fassung und einem Außenumfang der Scheibe befindet, drehbar gelagert, so dass die Scheibe sicher innerhalb der Führung gehalten und drehbar ist.

Weitere Merkmale und Zweckmäßigkeiten ergeben sich aus der Beschreibung von Ausführungsformen anhand der Figuren, von denen zeigt:
Fig. 1 eine Längsschnittansicht einer Kammeranordnung nach einer Ausführungsform der Erfindung;
Fig. 2 eine Querschnittsansicht einer Kammeranordnung nach einer Ausführungsform der Erfindung;
Fig. 3 eine vergrößerte Draufsicht einer Scheibe einer Kammeranordnung nach einer Ausführungsform der Erfindung;
Fig. 4 eine Längsschnittansicht einer herkömmlichen Kammeranordnung; und
Fig. 5 eine Querschnittsansicht der herkömmlichen Kammeranordnung.

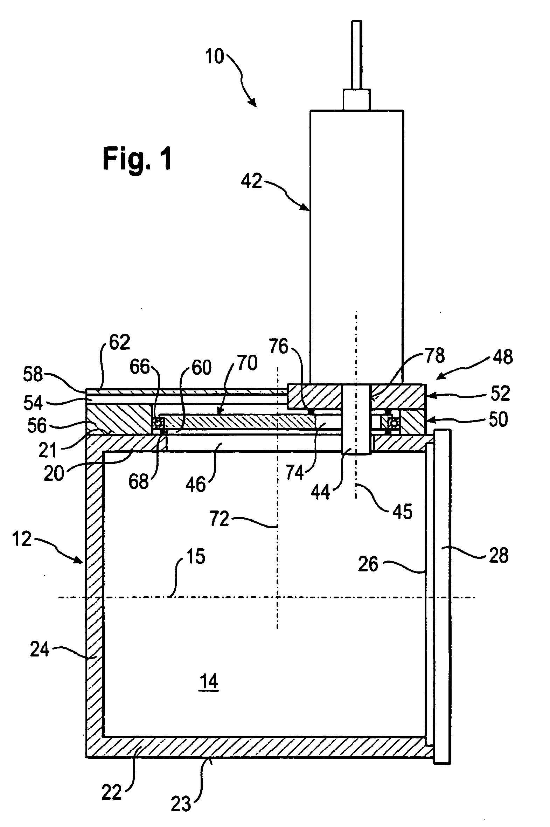

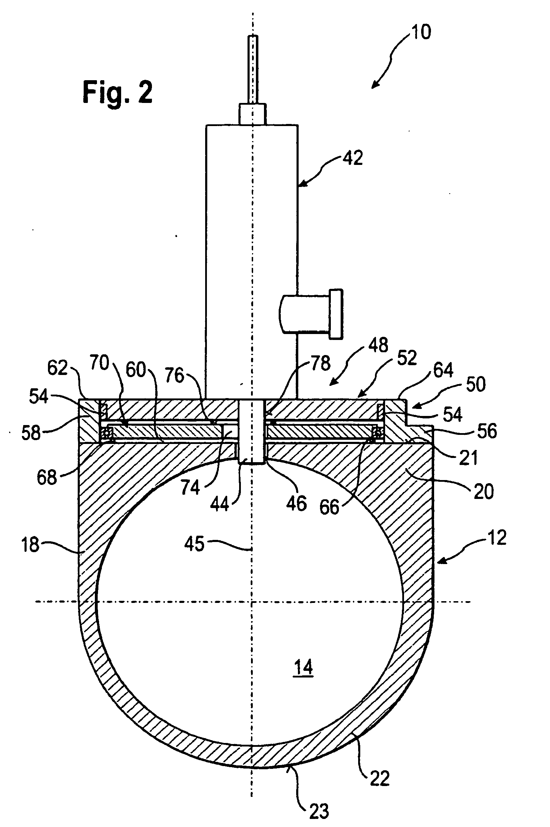

Fig. 1 bis 3 zeigen eine Kammeranordnung 10 gemäß einer Ausführungsform der Erfindung. Man beachte, dass Bauteile, die denen der eingangs in Verbindung mit Fig. 4 und Fig. 5 beschriebenen herkömmlichen Kammeranordnung entsprechen, durch gleiche Bezugszeichen angegeben sind. Im Folgenden wird nur auf die Unterschiede zu der in Fig. 4 und Fig. 5 beschriebenen herkömmlichen Kammeranordnung eingegangen. Im Übrigen gilt die Beschreibung der Fig. 4 und 5 auch für die Beschreibung der Ausführungsform.

Die Oberseite 21 des Kammergehäuses 12 ist eben und weist in ihrem mittleren Bereich eine erste Öffnung 46 auf, die schlitzförmig ausgebildet ist. Die erste, schlitzförmige Öffnung 46 erstreckt sich parallel zu der Längsachse 15. Wie der Darstellung der Fig. 1 zu entnehmen ist, beträgt der Abstand der ersten, schlitzförmigen Öffnung 46 bis zu der Be-/Entladeöffnung 26 ungefähr 25 % der Länge der ersten, schlitzförmigen Öffnung 46 und bis zu der Rückwand 24 ebenfalls ungefähr 25 % der Länge der ersten, schlitzförmigen Öffnung 46.

Die Kammeranordnung 10 weist weiter ein Schlittensystem 48 auf. Das Schlittensystem 48 weist eine Fassung 50, einen Schlitten 52 und zwei Linearführungen 54 auf. Die Fassung 50 weist eine Länge, die der Abmessung der Oberseite 21 in Richtung der Längsachse 15 (nachfolgend auch Längsrichtung) entspricht, und eine Breite, die der Abmessung der ebenen Oberseite 21 in einer Querrichtung, die senkrecht zu der Längsachse 15 ist, entspricht, auf. Die Fassung 50 weist in ihrer Höhenrichtung, die senkrecht zu der Längsrichtung und der Querrichtung ist, einen unteren Bereich 56 und einen oberen Bereich 58 auf, die integral miteinander ausgebildet sind. Der untere Bereich 56 weist eine kreisrunde Öffnung 60 auf. Der Durchmesser der Öffnung 60 ist größer als die Länge der ersten schlitzförmigen Öffnung 46. Der obere Bereich 58 ist als zwei quaderförmige Ansätze 62, 64 ausgebildet. Die Ansätze 62, 64 sind so ausgebildet, dass sie sich parallel zueinander beabstandet gegenüberliegen und über die gesamte Länge der Fassung 50 erstrecken. Der Abstand zwischen den sich zugewandten Seitenflächen der Ansätze 62, 64 entspricht dem Durchmesser der Öffnung 60. Die Mittellinie zwischen den sich zugewandten Seitenflächen der Ansätze 62, 64 geht durch den Mittelpunkt der Öff nung 60 des unteren Bereichs 58 der Fassung 50.

Die Fassung 50 ist so auf der Oberseite 21 des Kammergehäuses 12 angeordnet, dass die Ansätze 62, 64 parallel zu der ersten, schlitzförmigen Öffnung 46 sind und die Mittellinie zwischen den Ansätzen 62, 64 der Fassung 50 in Höhenrichtung gesehen deckungsgleich mit der Mittellinie der ersten, schlitzförmigen Öffnung 46 ist. Der Mittelpunkt der Öffnung 60 ist dabei um einen Abstand a in der Querrichtung der Fassung 50, der im Wesentlichen der 1,5 fachen Breite der ersten, schlitzförmigen Öffnung 46 entspricht, gegenüber der Mittellinie der Fassung 50 versetzt. Die Linearführungen 54 sind als Schienen ausgebildet und weisen die gleiche Länge wie die Ansätze 62, 64 auf. Die Linearführungen 54 sind an den sich zugewandten Seitenflächen der Ansätze 62, 64 angeordnet. Ein Lager 66, das als Kugellager ausgebildet ist und einen Durchmesser aufweist, der dem Durchmesser der Öffnung 60 angepasst ist, ist in der Öffnung 60 so angeordnet, dass das Lager 66 an dem Rand der Öffnung 60 angebracht ist. Das Lager 66 ist geeignet, Kräfte aufzunehmen, die in bzw. entgegen der Höhenrichtung wirken.

Ein Elektronenstrahlgenerator 42 weist ein Strahlrohr 44 auf, das an einer Unterseite des Elektronenstrahlgenerators 42 angeordnet und fest mit diesem verbunden ist.

Eine kreisrunde Scheibe 70 mit einem Durchmesser, der dem Durchmesser des Lagers 66 angepasst ist, ist in der Öffnung 60 so angeordnet, dass sie über das Lager 66 an ihrem Außenumfang um eine Drehachse 72 drehbar gelagert ist. Die Scheibe 70 liegt in einem in radialer Richtung gesehen äußeren Bereich mit ihrer dem Kammerinnenraum 14 zugewandten Seite auf der Dichtung 68 auf. Die Drehachse 72 verläuft in Höhenrichtung. Die Drehachse 72 verläuft durch den Mittelpunkt der Öffnung 60 und die Mittellinie zwischen den sich zugewandten Seitenflächen der Ansätze 62, 64. Das heißt, die Drehachse 72 der Scheibe 70 ist um den Abstand a gegenüber der Längsmittellinie der ersten schlitzförmigen Öffnung 46 in Querrichtung versetzt. Der Grund dafür wird später im Zusammenhang mit der Betriebsweise der Kammeranordnung 10 erläutert. Die Scheibe 70 weist eine zweite Öffnung 74 auf. Die zweite Öffnung 74 ist schlitzförmig ausgebildet und verläuft in radialer Richtung weg von der Drehachse 72. Die Drehachse 72 erstreckt sich nicht durch die zweite, schlitzförmige Öffnung 74. Die zweite, schlitzförmige Öffnung 74 weist eine Länge auf, die nicht größer als die halbe Länge der ersten, schlitzförmigen Öffnung 46 plus dem Durchmesser des Strahlrohrs 44 ist, und die bevorzugt gleich der halben Länge der ersten, schlitzförmigen Öffnung 46 plus dem Durchmesser des Strahlrohrs 44 abzüglich des Abstands a ist, so dass sich der in radialer Richtung der Scheibe 70 gesehen äußere Bereich der zweiten, schlitzförmigen Öffnung 74 und die beiden Endbereiche der ersten, schlitzförmigen Öffnung 46 abhängig von der Drehstellung der Scheibe 70 überdecken können. Eine Dichtung 76 ist auf der dem Kammerinnenraum 14 abgewandten Seite der Scheibe 70 so angeordnet, dass sie die zweite, schlitzförmige Öffnung 74 entlang deren Rand umgibt.

Eine kreisrunde Dichtung 68 mit einem Durchmesser, der größer als die Länge der ersten, schlitzförmigen Öffnung 46, aber kleiner als der Durchmesser der Scheibe 70 ist, ist auf der Oberseite 21 des Kammergehäuses 12, die erste, schlitzförmige Öffnung 46 so umgebend angeordnet, dass sich der Mittelpunkt der Dichtung 68 in Höhenrichtung gesehen mit dem Mittelpunkt der Öffnung 60 überdeckt. Das Lager 66 nimmt den Hauptteil der Kraft auf, die durch den Druckunterschied zwischen Kammerinnenraum 14 und Außenwelt auf die Scheibe 70 wirkt, so dass die Dichtung 68 nur einen Bruchteil dieser Kraft aufnimmt.

Der Elektronenstrahlgenerator 42 ist an seinem dem Kammerinnenraum 14 zugewandten unteren Ende mit einem Flansch 52 versehen, der das Strahlrohr 44 druckdicht umgibt. Der Flansch bildet bei dieser Ausführungsform gleichzeitig den Schlitten 52. Der Schlitten/Flansch (nachfolgend nur Schlitten genannt) 52 weist eine Breite in Querrichtung, die dem Abstand der Linearführungen 54 zueinander angepasst ist, und eine Länge in Längsrichtung, die größer als die doppelte Länge der zweiten, schlitzförmigen Öffnung 74 abzüglich des Durchmessers des Strahlrohrs 44 ist, auf. Der Schlitten 52 weist in seiner Mitte eine runde Öffnung 78 mit einem Durchmesser, der kleiner als die Breite der zweiten, schlitzförmigen Öffnung 74 ist, auf. Der Schlitten 52 ist so zwischen den Ansätzen 62, 64 des oberen Bereichs 56 der Fassung 50 angeordnet, dass er zwischen diesen, geführt von den Linearführungen 54, linear bewegbar ist und als Flansch auf der Dichtung 76 aufliegt. Der Schlitten/Flansch 52 ist dabei wiederum vorzugsweise so gelagert, dass der Hauptteil der durch den Druckunterschied erzeugten Kraft nicht von der Dichtung 76, sondern dem (nicht gezeigten) Lager aufgenommen wird.

Der Elektronenstrahlgenerator 42 ist auf der dem Kammerinnenraum 14 abgewandten Seite des Schlittens 52 so angeordnet, dass der Elektronenstrahlgenerator 42, die Öffnung 78 fluiddicht umgebend, mit dem Schlitten 52 verbunden ist. Das Strahlrohr 44 weist eine einen Durchmesser, der kleiner als der Durchmesser der Öffnung 78 und kleiner als die Breite der beiden schlitzförmigen Öffnungen 46, 74 ist, auf, und steht gegenüber der Unterseite des Elektronenstrahlgenerators 42 um eine Länge vor, die größer als die kombinierte Höhe von Schlitten 52, Scheibe 70 und erster, schlitzförmiger Öffnung 46 ist, so dass das Strahlrohr 44 durch die Öffnung 78, durch die zweite, schlitzförmige Öffnung 74 und in die erste, schlitzförmige Öffnung 46 ragt. Der Elektronenstrahlgenerator 42 ist angepasst zum Erzeugen eines Elektronenstrahls, der sich durch das Strahlrohr 44 entlang einer Elektronenstrahlachse 45 in den Kammerinnenraum 14 fortpflanzt. Das Bewegen des Schlittens 52 erfolgt über einen nicht gezeigten Antrieb. Durch die Dichtungen 68, 76, die Scheibe 70 und den Schlitten 52 ist der Kammerinnenraum 14 gegenüber der Umgebung bzw. der Atmosphäre abgedichtet. Bei der gezeigten Ausführungsform ist das Strahlrohr ohne Spiel in die zweite, schlitzförmige Öffnung 74 der Scheibe 70 eingesetzt, und die Scheibe 70 wird durch die Bewegung des Strahlrohrs 44 um ihre Drehachse 72 gedreht.

Die übrigen Elemente der Elektronenstrahlbearbeitungsvorrichtung, wie beispielsweise eine Ein-/Auslassöffnung zum Evakuieren der und zum Einlassen von Fluid in die Kammer, eine Pumpstation, Ablenkspulen, Anschlüsse für den Elektronenstrahlgenerator, Antriebe zum Bewegen des Schlittens usw., die an dem oder in dem Kammergehäuse bzw. der Fassung anzuordnen sind, sind herkömmlich und bekannt, so dass eine Beschreibung dieser Elemente weggelassen wird.

Die Kammeranordnung 10 kann bautechnische Alternativen aufweisen. Im Folgenden werden einige Varianten beschrieben.

Der Flansch an dem Elektronenstrahlgenerator, der die zweite Öffnung in der Scheibe abdeckt, und der Schlitten können separat ausgebildet sein.

Das Lager 66 kann alternativ oder zusätzlich zu der Anordnung am Außenumfang der Scheibe 70 (oder von dem Ansatz) auch zwischen der Scheibe 70 und dem Kammergehäuse 12 angeordnet sein.

Der Abstand der Enden der ersten, schlitzförmigen Öffnung 46 zu der Rückwand 24 und der Be-/Entladeöffnung 26 liegt jeweils im Bereich von 0 bis 100 % der Länge der ersten, schlitzförmigen Öffnung 46, bevorzugt im Bereich von 5 bis 50 %, noch bevorzugter im Bereich von 5 bis 25 %.

Der Abstand a liegt vorzugsweise im Bereich von 0 bis halber Radius der Scheibe.

Die erste Öffnung muss nicht in der Oberseite des Kammergehäuses ausgebildet sein, sondern kann in jeder Wand des Kammergehäuses ausgebildet sein.

Die erste Öffnung muss nicht schlitzförmig sein, sondern kann jeden Umriss in Draufsicht aufweisen, der innerhalb der Dichtung 68 der Scheibe 70 liegt, z.B. kreisrund, quadratisch, rechteckig etc. Auch ist es möglich mehr als eine erste Öffnung vorzusehen.

Die zweite Öffnung muss auch nicht schlitzförmig sein, ist es aber vorzugsweise.

Die Scheibe kann von einem eigenen Antrieb gedreht werden. Die Scheibe kann dazu beispielsweise an ihrem Außenumfang zwischen dem Lager und dem Schlitten einen Zahnkranz aufweisen, in den ein Zahnrad des Antriebs greift. Der Zahnkranz kann auch zwischen dem Lager und der Oberseite des Kammergehäuses angeordnet sein. Bei einer Drehung der Scheibe drückt der Rand der zweiten, schlitzförmigen Öffnung gegen das Strahlrohr des Elektronenstrahlgenerators, so dass der Schlitten mitbewegt wird.

Der Flansch ist, wie bereits erwähnt, alternativ nicht integral mit dem Schlitten ausgebildet.

Das ermöglicht einen sogenannten XY-Schlitten, das heißt einen Schlitten mit zwei senkrecht zueinander bewegbaren Schlittenteilen. Der XY-Schlitten trägt den Elektronenstrahlgenerator derart, dass das Strahlrohr durch die Öffnung in dem Flansch, durch die zweite (schlitzförmige) Öffnung in die erste Öffnung ragt, so dass sich ein Elektronenstrahl durch das Strahlrohr in den Kammerinnenraum fortpflanzen kann.

Eine Ausbildung der zweiten Öffnung derart, dass das Strahlrohr in einer Position konzentrisch zur Drehachse der Scheibe bewegt werden kann, erlaubt dem Elektronenstrahlgenerator kombiniert mit dem XY-Schlitten, dass das Strahlrohr an jeden Punkt innerhalb der Ebene der ersten Öffnung bewegt werden kann, ohne dass das Schlittensystem in dem Maß wie bei der herkömmlichen Kammeranordnung über das Kammergehäuse vorsteht.

Die beschriebene Entkoppelung des Schlittens und des Flanschs ermöglicht die Abdichtung des Kammerinnenraums gegenüber der Umgebung bzw. der Atmosphäre durch die Dichtung zwischen Kammergehäuse und der Scheibe und zwischen der Scheibe und dem Flansch unabhängig von dem Schlitten.

Da das Drehmoment zum Drehen der Scheibe bei der oben beschriebenen Ausführungsform mittels des Strahlrohrs bei einer Bewegung des Strahlrohrs in Richtung zu der Drehachse der Scheibe abnimmt, kann alternativ oder zusätzlich ein Antrieb, wie beispielsweise ein Servoantrieb, zum Drehen der Scheibe vorgesehen sein. Das ist insbesondere vorteilhaft bei einer entsprechenden Größe der zweiten Öffnung derart, dass die zweite Öffnung die Drehachse der Scheibe schneidet.

Die Be-/Entladeöffnung kann an jeder Seite des Kammergehäuses vorgesehen sein. Es können mehrere Be-/Entladeöffnungen vorgesehen sein, die in beliebigen Positionen am Kammergehäuse angeordnet sein können. Das Kammergehäuse kann jede beliebige Form aufweisen. Beispielsweise kann das Kammergehäuse würfel-, kasten-, oder kugelförmig ausgebildet sein. Es ist hinreichend, wenn das Kammergehäuse einen Bereich an der Seite, an der das Schlittensystem anzuordnen ist, so ausgebildet ist, dass die Fassung darauf montiert werden kann. Dies kann beispielsweise über einen ringförmigen Ansatz bei einer Kugelform erreicht werden. Anstelle der Dichtung um den Rand der Be-/Entladeöffnung können die Türen die Dichtung auf weisen.

Die Betriebsweise der Kammeranordnung 10 wird im Folgenden anhand der Figuren 1 bis 3 beschrieben.

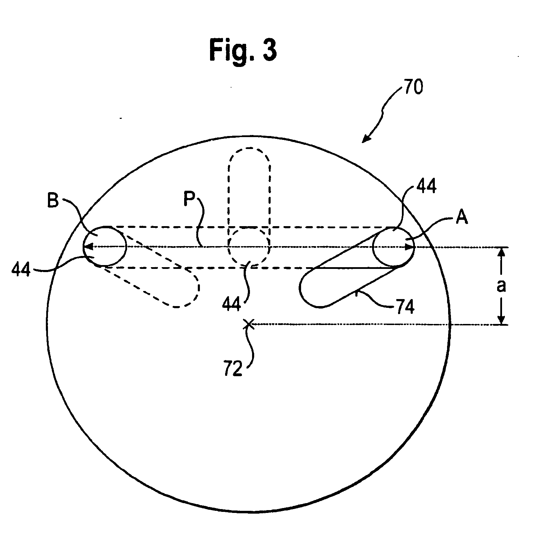

In der Darstellung der Fig.1 befindet sich der Schlitten 52 auf der rechten Seite des Kammergehäuses 12, d.h. auf der Seite der Be-/Entladeöffnung 26. Folglich ist der Elektronenstrahlgenerator 42 mit dem Strahlrohr 44 auf der rechten Seite der ersten, schlitzförmigen Öffnung 46. Diese Position entspricht einer ersten Position A sowohl des Schlittens 52 als auch der Scheibe 70. Während eines Bearbeitungsvorgangs, wie beispielsweise dem Elektronenstrahlschweißen unter Vakuum bzw. Unterdruck, der bei der beschriebenen Kammeranordnung 10 gemäß einer Ausführungsform der Erfindung 10⁻¹ mbar bis 10⁻⁶ mbar betragen kann, wird der Schlitten 52 in Richtung zu der Rückwand 24 durch den nicht gezeigten Antrieb bewegt. Das heißt, der Schlitten 52 bewegt sich zusammen mit dem Elektronenstrahlgenerator 42 in der Darstellung der Fig. 1 nach links. Da die Drehachse 72 der Scheibe 70 von der ersten, schlitzförmigen Öffnung 46 beabstandet ist, decken sich die erste, schlitzförmige Öffnung 46 und die zweite, schlitzförmige Öffnung 74 nicht vollständig, sondern mindestens im Bereich der Elektronenstrahlachse 45 bzw. im Bereich des Strahlrohrs 44. Dadurch drückt bei einer Bewegung des Schlittens 52 das Strahlrohr 44 gegen den Rand der zweiten, schlitzförmigen Öffnung 74 in der Scheibe 70. Folglich wirkt um die Drehachse 72 der Scheibe 70 ein Drehmoment, so dass sich während der Bewegung des Schlittens 52 nach links die Scheibe 70 auf dem Lager 66 um die Drehachse 72 in Umfangsrichtung nach links dreht. Dadurch scheint es in der Ansicht der Fig. 3, dass sich das Strahlrohr 44 in der zweiten, schlitzförmigen Öffnung 74 erst radial nach innen und dann wieder radial nach außen bewegt, wie in der Darstellung der Fig. 3 durch die Angabe von verschiedenen Positionen des Strahlrohrs 44 während der Bewegung des Schlittens 52 zu sehen ist. In Wirklichkeit bewegt sich der Schlitten 52 linear nach links und dreht mit Hilfe des Strahlrohrs 44 die Scheibe 70, so dass sich die zweite, schlitzförmige Öffnung 74 relativ zu dem Strahlrohr 44 bewegt. Die Scheibe 70 wird also bei einer Bewegung des Schlittens 52 durch das Strahlrohr 44 mitbewegt bzw. mitgedreht. Dadurch, dass der Schlitten 52 direkt mittels des Antriebs bewegt wird, kann der Schlitten exakt positioniert werden, so dass eine hohe Positionsgenauigkeit für den Elektronenstrahl möglich ist.

Ist der Schlitten 52 ganz nach links gefahren, befindet sich die Scheibe 70 in ihrer zweiten Position B. In dieser Position B befindet sich das Strahlrohr 44 links in der zweiten, schlitzförmigen Öffnung 74. Es versteht sich, dass der Schlitten 52 auch umgekehrt bewegt werden kann, d.h. in der Darstellung der Fig. 1 von links nach rechts. Auch eine Hin- und Herbewegung ist möglich, wie durch einen gepunkteten Doppelpfeil P in Fig. 3 angegeben ist.

### Bezugszeichenliste

- 10: Kammeranordnung
- 12: Kammergehäuse
- 14: Kammerinnenraum
- 15: Längsachse
- 16: Seitenwand
- 18: Seitenwand
- 20: obere Wand
- 21: Oberseite
- 22: untere Wand
- 23: Unterseite
- 24: Rückwand
- 26: Be-/Entladeöffnung
- 28: Tür
- 30: schlitzförmige Öffnung
- 31: Dichtung
- 32: Schlittensystem
- 34: Fassung
- 36: Schlitten
- 38: Linearführung
- 40: Öffnung
- 42: Elektronenstrahlgenerator
- 44: Strahlrohr
- 45: Elektronenstrahlachse
- 46: erste Öffnung
- 48: Schlittensystem
- 50: Fassung
- 52: Schlitten
- 54: Linearführung
- 56: unterer Bereich
- 58: oberer Bereich
- 60: Öffnung

- 62: Ansatz
- 64: Ansatz
- 66: Lager
- 68: Dichtung
- 70: Scheibe
- 72: Drehachse
- 74: zweite Öffnung
- 76: Dichtung
- 78: Öffnung
- A: erste Position
- B: zweite Position
- P: Doppelpfeil

## Patentansprüche

1. Kammeranordnung für eine Elektronenstrahlbearbeitungsvorrichtung, mit
einem Kammergehäuse (12), das einen Kammerinnenraum (14) definiert und eine erste Öffnung (46) aufweist,
einem Schlitten (52), der im Bereich der ersten Öffnung (46) bewegbar ist,
einem Elektronenstrahlgenerator (42) zum Erzeugen eines Elektronenstrahls entlang einer Elektronenstrahlachse (45), wobei der Elektronenstrahlgenerator (42) an dem Schlitten (52) so angeordnet ist, dass bei einer Bewegung des Schlittens (52) im Bereich der ersten Öffnung (46) der Elektronenstrahl durch die erste Öffnung (46) hindurchgeht, und
einer Scheibe (70), die zwischen dem Kammergehäuse (12) und dem Schlitten (52) angeordnet ist und um eine Drehachse (72), die senkrecht zu der ersten Öffnung (46) ist, wenigstens zwischen einer ersten Position (A) und einer zweiten Position (B) drehbar ist und eine zweite Öffnung (74) mindestens in einem Bereich der Scheibe (70), der sich in radialer Richtung von der Drehachse (72) der Scheibe (70) weg erstreckt, aufweist, und die Drehachse (72) der Scheibe (70) so angeordnet ist, dass sich die erste Öffnung (46) und die zweite Öffnung (74) bei einer Drehung der Scheibe (70) zwischen der ersten Position (A) und der zweiten Position (B) wenigstens im Bereich der Elektronenstrahlachse (45) überdecken.

2. Kammeranordnung nach Anspruch 1, bei der die erste Öffnung (46) kreisrund ist.

3. Kammeranordnung nach Anspruch 1, bei der die erste Öffnung (46) schlitzförmig ist.

4. Kammeranordnung nach einem der vorhergehenden Ansprüche, bei der die zweite Öffnung (74) schlitzförmig ist.

5. Kammeranordnung nach einem der vorhergehenden Ansprüche, bei der ein Flansch (52) an dem Elektronenstrahlgenerator (42) vorgesehen ist, und eine Dichtung (76) zwischen dem Flansch (52) und der Scheibe (70) die zweite Öffnung (74) umgebend und eine Dichtung (68) zwischen der Scheibe (70) und dem Kammergehäuse (12) die erste Öffnung (46) umgebend vorgesehen sind.

6. Kammeranordnung nach Anspruch 5, bei der der Flansch (52) integral mit dem Schlitten (52) ausgebildet ist.

7. Kammeranordnung nach Anspruch 5, bei der der Flansch (52) und der Schlitten (52) zwei separate Teile sind.

8. Kammeranordnung nach Anspruch 7, die einen XY-Schlitten als Schlitten aufweist.

9. Kammeranordnung nach einem der vorhergehenden Ansprüche, bei der der Elektronenstrahlgenerator (42) ein Strahlrohr (44) aufweist.

10. Kammeranordnung nach Anspruch 9, bei der die Scheibe (70) durch das Strahlrohr (44) gedreht wird.

11. Kammeranordnung nach einem der vorhergehenden Ansprüche, bei der die Scheibe (70) durch einen Antrieb zur Drehung antreibbar ist.

12. Kammeranordnung nach einem der Ansprüche 9 bis 11, bei der die zweite Öffnung (74) eine Länge aufweist, die nicht größer als die halbe Länge der ersten Öffnung (46) plus dem Durchmesser des Strahlrohrs (44) des Elektronenstrahlgenerators (42) ist.

13. Kammeranordnung nach einem der vorhergehenden Ansprüche, bei der die Drehachse (72) der Scheibe (70) nicht durch die zweite Öffnung (74) verläuft.

14. Kammeranordnung nach einem der vorhergehenden Ansprüche, die eine Fassung (50) mit parallel zueinander beanstandeten Ansätzen (62, 64) aufweist und bei der der Schlitten (52) an zwei sich zugewandten Seitenflächen der Ansätze (62, 64) geführt ist.

15. Kammeranordnung nach Anspruch 14, bei der die Scheibe (70) durch ein Lager (66), das sich zwischen der Fassung (50) und einem Außenumfang der Scheibe (70) befindet, drehbar gelagert ist.

## Claims

1. Chamber arrangement for an electron beam processing device, comprising:
a chamber housing (12) that defines a chamber interior space (14) and has a first opening (46),
a carriage (52) that is movable in the range of the first opening (46),
an electron beam generator (42) for generating an electron beam along an electron beam axis (45), wherein the electron beam generator (42) is disposed on the carriage (52) such that the electron beam passes through the first opening (46) when the carriage (52) moves in the range of the first opening (46), and
a disk (70) that is disposed between the chamber housing (12) and the carriage (52) and is rotatable about a rotational axis (72) perpendicular to the first opening (46) at least between a first position (A) and a second position (B) and has a second opening (74) at least in a portion of the disk (70) that extends away from the rotational axis (72) of the disk (70) in the radial direction, and the rotational axis (72) of the disk (70) is disposed such that the first opening (46) and the second opening (74) overlap at least in the region of the electron beam axis (45) when the disk (70) rotates between the first position (A) and the second position (B).

2. Chamber arrangement according to claim 1, wherein the first opening (46) is circular.

3. Chamber arrangement according to claim 1, wherein the first opening (46) is slot-shaped.

4. Chamber arrangement according to any one of the preceding claims, wherein the second opening (74) is slot-shaped.

5. Chamber arrangement according to any one of the preceding claims, wherein a flange (52) is provided on the electron beam generator (42) and a seal (76) is provided between the flange (52) and the disk (70) enclosing the second opening (74) and a seal (68) is provided between the disk (70) and the chamber housing (12) enclosing the first opening (46).

6. Chamber arrangement according to claim 5, wherein the flange (52) is integrally formed with the carriage (52).

7. Chamber arrangement according to claim 5, wherein the flange (52) and the carriage (52) are two separate parts.

8. Chamber arrangement according to claim 7, including an X-Y carriage as the carriage.

9. Chamber arrangement according to any one of the preceding claims, wherein the electron beam generator (42) includes a beam nozzle (44).

10. Chamber arrangement according to claim 9, wherein the disk (70) is rotated by the beam nozzle (44).

11. Chamber arrangement according to any one of the preceding claims, wherein the disk (70) is drivable by a drive to rotate.

12. Chamber arrangement according to any one of claims 9 to 11, wherein the second opening (74) has a length that is not greater than half the length of the first opening (46) plus the diameter of the beam nozzle (44) of the electron beam generator (42).

13. Chamber arrangement according to any one of the preceding claims, wherein the rotational axis (72) of the disk (70) does not extend through the second opening (74).

14. Chamber arrangement according to any one of the preceding claims, including a support (50) having parallel spaced-apart projections (62, 64), wherein the carriage (52) is guided on two facing side surfaces of the projections (62, 64).

15. Chamber arrangement according to claim 14, wherein the disk (70) is rotatably borne by a bearing (66) that is located between the support (50) and an outer periphery of the disk (70).

## Revendications

1. Aménagement de chambre pour un dispositif d'usinage par faisceau électronique, comprenant :
une enceinte de chambre (12), qui définit un espace interne de chambre (14) et qui présente une première ouverture (46),
un coulisseau (52), qui peut être déplacé dans la zone de la première ouverture (46),
un générateur de faisceau électronique (42) pour générer un faisceau électronique le long d'un axe de faisceau électronique (45), dans lequel le générateur de faisceau électronique (42) est agencé sur le coulisseau (52) de sorte que le faisceau électronique traverse la première ouverture (46) lors d'un mouvement du coulisseau (52) dans la zone de la première ouverture (46), et
un disque (70), qui est agencé entre l'enceinte de chambre (12) et le coulisseau (52) et qui peut tourner autour d'un axe de rotation (72), qui est perpendiculaire à la première ouverture (46), au moins entre une première position (A) et une seconde position (B) et qui présente une seconde ouverture (74) au moins dans une zone du disque (70), qui s'éloigne dans la direction radiale de l'axe de rotation (72) du disque (70), l'axe de rotation (72) du disque (70) étant agencé de sorte que la première ouverture (46) et la seconde ouverture (74) se recouvrent lors d'une rotation du disque (70) entre la première position (A) et la seconde position (B) au moins dans la zone de l'axe de faisceau électronique (45).

2. Agencement de chambre selon la revendication 1, dans lequel la première ouverture (46) est circulaire.

3. Agencement de chambre selon la revendication 1, dans lequel la première ouverture (46) est en forme de fente.

4. Agencement de chambre selon l'une quelconque des revendications précédentes, dans lequel la seconde ouverture (74) est en forme de fente.

5. Agencement de chambre selon l'une quelconque des revendications précédentes, dans lequel il est prévu une bride (52) sur le générateur de faisceau électronique (42) et il est prévu un joint étanche (76) entre la bride (52) et le disque (70) entourant la seconde ouverture (74) et un joint étanche (68) entre le disque (70) et l'enceinte de chambre (12) entourant la première ouverture (46).

6. Agencement de chambre selon la revendication 5, dans lequel la bride (52) est formée de manière solidaire avec le coulisseau (52).

7. Agencement de chambre selon la revendication 5, dans lequel la bride (52) et le coulisseau sont deux parties séparées.

8. Agencement de chambre selon la revendication 7, qui présente un coulisseau XY comme coulisseau.

9. Agencement de chambre selon l'une quelconque des revendications précédentes, dans lequel le générateur de faisceau électronique (42) présente un tube de faisceau (44).

10. Agencement de chambre selon la revendication 9, dans lequel le disque (70) est soumis à une rotation par le tube de faisceau (44).

11. Agencement de chambre selon l'une quelconque des revendications précédentes, dans lequel le disque (70) peut être entraîné en rotation par un dispositif d'entraînement.

12. agencement de chambre selon l'une quelconque des revendications 9 à 11, dans lequel la seconde ouverture (74) présente une longueur qui n'est pas supérieure à la demi-longueur de la première ouverture (46) plus le diamètre du tube de faisceau (44) du générateur de faisceau électronique (42).

13. Agencement de chambre selon l'une quelconque des revendications précédentes, dans lequel l'axe de rotation (72) du disque (70) ne s'étend pas à travers la seconde ouverture (74).

14. Agencement de chambre selon l'une quelconque des revendications précédentes, qui présente une douille (50) avec des épaulements (62, 64) espacés parallèlement l'un à l'autre et dans lequel le coulisseau (52) est guidé sur deux surfaces latérales des épaulements (62, 64) tournées l'une vers l'autre.

15. Agencement de chambre selon la revendication 14, dans lequel le disque (70) est monté à rotation par un palier (66), qui se trouve entre la douille (50) et un pourtour externe du disque (70).
